# EUROPÄISCHE PATENTSCHRIFT

(11) **EP 1 972 060 B1**
(45) Veröffentlichungstag und Bekanntmachung des Hinweises auf die Patenterteilung: **19.12.2018**
(21) Anmeldenummer: 07785791.0
(22) Anmeldetag: 04.01.2007
(51) Int. Cl.: G01R 27/28, H03L 7/07, H03L 7/087, H03L 7/23

(54) **ANORDNUNG ZUR PHASENSYNCHRONISATION NACH DEM MASTER/SLAVE-PRINZIP**
APPARATUS FOR PHASE SYNCHRONISATION ACCORDING TO THE MASTER/SLAVE PRINCIPLE
AGENCEMENT POUR LA SYNCHRONISATION DE PHASES SELON LE PRINCIPE MAÎTRE/ESCLAVE

(30) Priorität: 10.01.2006 DE 102006001284; 26.01.2006 DE 102006003839
(43) Veröffentlichungstag der Anmeldung: 24.09.2008
(73) Patentinhaber: Rohde & Schwarz GmbH & Co. KG, 81671 München (DE)
(72) Erfinder: ORTLER, Georg, 86459 Gessertshausen (DE)
(74) Vertreter: Körfer, Thomas
(86) Internationale Anmeldenummer: PCT/EP2007/000042
(87) Internationale Veröffentlichungsnummer: WO 2007/124788

(56) Entgegenhaltungen:
- DE-A1- 10 123 932
- DE-A1- 10 246 700
- DE-A1- 10 331 092
- US-A- 4 511 859
- US-A- 6 147 562
- US-A- 6 163 223

## Beschreibung

Die Erfindung betrifft eine Anordnung zur Phasensynchronisation.

Eine gattungsgemäße Anordnung zur Phasensynchronisation ist aus der DE 103 31 092 A1 bekannt. Bei dieser Anordnung zur Phasensynchronisation sind mehrere Meßgeräte, insbesondere Netzwerkanalysatoren, zu einem Meßsystem zusammengefasst. Die einzelnen Meßgeräte sind über eine Verbindungsleitung so miteinander verbunden, dass die einzelnen Phasenregelschleifen (PLL = phase locked loop) die gleiche Referenzfrequenz erhalten. Bei dieser Ausgestaltung gibt es kein übergeordnetes Gerät (Master) und untergeordnete Geräte (Slaves), sondern alle Geräte sind gleichberechtigt. Dieses Regelkonzept kann beim Zusammenschalten nur weniger, beispielsweise nur zwei oder drei, Geräte durchaus befriedigende Ergebnisse liefern. Sollen jedoch sehr viele Geräte zusammengeschaltet werden, so hat die Anordnung eine relativ lange Einschwingzeit und es können relativ lange Zeit Phasenfluktuationen auftreten.

Aus der DE 102 46 700 A1 ist ein vektorieller Netzwerkanalysator mit steuerbaren Signalgeneratoren und steuerbaren Oszillatoren bekannt. Ein Hinweis darauf, wie mehrere solche Geräte miteinander synchronisiert werden können, ist dort jedoch nicht enthalten.

Aus der US 6,147,562 A ist ein Gerät bekannt, das eine Taktsynchronisierung für Prozessoren einer Master-and-Slave Anordnung umfasst, wobei die Phasenverschiebung des an beiden Prozessoren anliegenden Taktes möglichst klein sein soll. Jede Vorrichtung kann entweder als Master oder als Slave arbeiten. Der Master selbst gibt seinen Systemtakt, der durch einen VCO mittels Referenzsignalen generiert wird, zusätzlich an einen Slave weiter. Der Slave selbst verbindet die Systemtaktleitung, welche vom Master kommt, mit einem Phasendetektor. Der andere Eingang des Phasendetektors wird vom Systemtakt des Slave gespeist, welcher über eine Delayline verzögert werden kann. Der Ausgang des Phasendetektors wird mit einem Filter verbunden, welcher bei einem Slavesystem mit dem VCO verbunden ist. Der VCO generiert den Systemtakt für das Slavesystem, dessen Takt eine sehr geringe Phasenabweichung zum Systemtakt des Mastersystems aufweist.

Aus der US 4,511,859 A ist ein Gerät bekannt, das zwei PLL-Regelschleifen, eine Umschalteinrichtung und eine Kontrolleinrichtung aufweist. Beide PLL-Regelschleifen beinhalten einen Phasenkomparator, einen Schleifenfilter mit einem Kontroller und einen Frequenzteiler und können über einen Wahlschalter mit dem Eingang eines VCO verbunden werden. Beide Schleifenfilter werden von einer Kontrolleinrichtung, die aus einem einfachen Potentiometer oder auch einem Rechengerät bestehen kann, angesteuert. Dadurch, dass das zweite Schleifenfilter von einem Rechengerät angesteuert wird, welches sowohl den Ausgang der ersten, als auch der zweiten PLL-Regelschleife überwacht, kann über einen Schalter der Eingang des VCO statt mit dem Ausgang der ersten PLL-Regelschleife nun mit dem Ausgang der zweiten PLL-Regelschleife verbunden werden, ohne dass im Ausgangssignal des VCO eine Phasenverschiebung eintritt.

Aus US-6,163,223 A ist eine lokale Signalquelle mit einer Vielzahl von Phasenregelschleifen (phase locked loop PLL)bekannt, die anhand von Umschalteinrichtungen an verschiedene Oszillatoren angekoppelt werden können.

Aus der DE 101 23 932 A ist eine Vorrichtung zur Erzeugung eines internen Taktes für Telekommunikationssysteme bekannt, bei der mindestens zwei redundante Referenztakte von einer Master-Einheit zu einer Slave-Einheit zur Synchronisation der Slave-Einheit anhand einer Synchronisationseinheit mit mehreren Phasenregelkreisen übertragen werden, wobei eine automatische Umschaltung zwischen den Referenzsignalen abhängig von der Qualität der erzeugten lokalen Signale erfolgt.

Der Erfindung liegt daher die Aufgabe zugrunde, eine Anordnung zur Phasensynchronisation zu schaffen, die auch beim Zusammenschalten vieler Geräte zuverlässig funktioniert und eine kurze Einschwingzeit hat.

Die Erfindung wird durch die Anordnung zur Phasensynchronisation mit dem Merkmal des Anspruchs 1 gelöst. Die Unteransprüche enthalten vorteilhafte Weiterbildungen der Erfindung.

Der Erfindung liegt das Konzept zugrunde, jeweils ein Gerät als Haupt-Gerät (Master) zu betreiben und die anderen Meßgeräte diesem Haupt-Gerät unterzuordnen (Slaves). Dabei ist für jedes Gerät jeweils eine Phasensynchronisations-Einheit vorgesehen, die einen geregelten Oszillator zur Erzeugung eines Haupt-Referenzsignals aufweist. Außerdem ist ein erster Phasendetektor zur Regelung dieses Oszillators nach dem PLL-(phase locked loop)-Prinzip vorhanden. Es wird in der geschlossenen Phasenregelschleife aber nur dann dieser erste Phasendetektor verwendet, wenn das betreffende Gerät das Haupt-Gerät (Master) ist. In diesem Fall wird das ggf. in einem Teiler heruntergeteilte Haupt-Referenzsignal mit einem, ggf. auch heruntergeteilten, Hilfs-Referenzsignal bezüglich seiner Phase verglichen. Den anderen, untergeordneten Geräten (Slaves) wird das Haupt-Referenzsignal über eine Verbindungsleitung übermittelt. Diese untergeordneten Geräte (Slaves) verwenden dann für den Phasenvergleich in einem zweiten Phasendetektor nicht das Hilfs-Referenzsignal, sondern dieses von dem Haupt-Gerät (Master) übermittelte Haupt-Referenzsignal.

Dies führt dazu, dass alle Phasenregelschleifen in allen Geräte auf das gleiche Referenzsignal synchronisiert werden, das durch das Haupt-Gerät (Master) vorgegeben wird. Beim Stand der Technik nach der DE 103 31 092 A1 hingegen ist nur eine lose Kopplung der Phasenregelschleifen der einzelnen Geräte über Trenntransformatoren vorhanden und alle Phasenregelschleifen müssen sich aufeinander einschwingen. Durch das erfindungsgemäße Konzept der Einprägung des von den untergeordneten Geräten (Slaves) zwingend zu verwendenden Referenzsignals durch das Haupt-Gerät (Master) wird demgegenüber eine wesentlich kürzere Einschwingzeit erreicht.

Dabei können der erste Phasendetektor zur Synchronisation mit dem internen Haupt-Referenzsignal und der zweite Phasendetektor zur Synchronisation mit dem externen Haupt-Referenzsignal identisch sein, d.h. es kann sich physikalisch um den gleichen Phasendetektor handeln, wenn zwischen dem externen Haupt-Referenzsignal und dem internen Haupt-Referenzsignal umgeschaltet wird. Bevorzugt sind jedoch zwei Phasendetektoren vorhanden, die ständig eingeschwungen sind, und es wird am Ausgang der Phasendetektoren zur Regelung des Oszillators durch eine erste Umschalteinrichtung umgeschaltet, je nachdem ob das betreffende Gerät das übergeordnete Gerät (Master) oder das untergeordnete Gerät (Slave) ist. Über eine zweite Umschalteinrichtung kann das Haupt-Referenzsignal auf die Verbindungsleitung mit den anderen Geräten geschaltet werden, wenn das betreffende Gerät das Haupt-Gerät (Master) ist.

Die in den Phasendetektoren zu vergleichenden Signale können dem Phasendetektor entweder direkt oder über entsprechende Teiler, welche die Frequenz durch einen vorgegebenen Teilerfaktor teilen, zugeführt werden.

Die Phasensynchronisationseinheiten enthalten eine zweite ähnlich aufgebaute Anordnung zur Synchronisation des Takts für die Analog/Digital-Wandler. Es ist nicht nur wichtig, dass die Referenzsignale für die Generatoren und lokalen Oszillatoren der Geräte exakt phasensynchron sind, sondern es muss auch bevorzugt eine möglichst gute Phasensynchronität der die Abtastzeitpunkte festlegenden Taktsignale für die Analog/Digital-Wandler vorhanden sein. Dadurch wird sichergestellt, dass die einzelnen Geräte die Abtastwerte zur exakt gleichen Zeiten abtasten.

Auch bei der Synchronisation des Taktsignals für die Analog/Digital-Wandler sind bevorzugt zwei getrennte Phasendetektoren vorhanden. Dabei kommt ein erster Phasendetektor für den Fall zum Einsatz, dass es sich bei dem betreffenden Gerät um das Haupt-Gerät (Master) handelt, so dass auf das Ausgangssignal des internen Taktgenerators synchronisiert wird. Der andere Phasendetektor kommt zum Einsatz, wenn es sich bei dem betreffenden Gerät um ein untergeordnetes Gerät (Slave) handelt, so dass auf das von dem Haupt-Gerät (Master) extern zugeführte Taktsignal synchronisiert wird. Es ist aber im Rahmen der Erfindung auch möglich, dass der dritte und vierte Phasendetektor für diese beiden Aufgaben physikalisch durch einen gemeinsamen Phasendetektor repräsentiert wird und eines der Vergleichssignale entsprechend umgeschaltet wird.

Ein Ausführungsbeispiel der Erfindung wird nachfolgend unter Bezugnahme auf die Zeichnung beschrieben. In der Zeichnung zeigen:
- Fig. 1: ein Blockschaltbild der erfindungsgemäßen Anordnung zur Phasensynchronisation;
- Fig. 2: ein Ausführungsbeispiel eines vektoriellen Netzwerkanalysators mit der erfindungsgemäßen Phasensynchronisation;
- Fig. 3: ein Ausführungsbeispiel einer Phasensynchronisastions-Einheit zur Synchronisation einer Referenzfrequenz und eines Taktsignals; und
- Fig. 4: ein Ausführungsbeispiel eines Signalgenerators, welcher die erfindungsgemäße Phasensynchronisation benutzt.

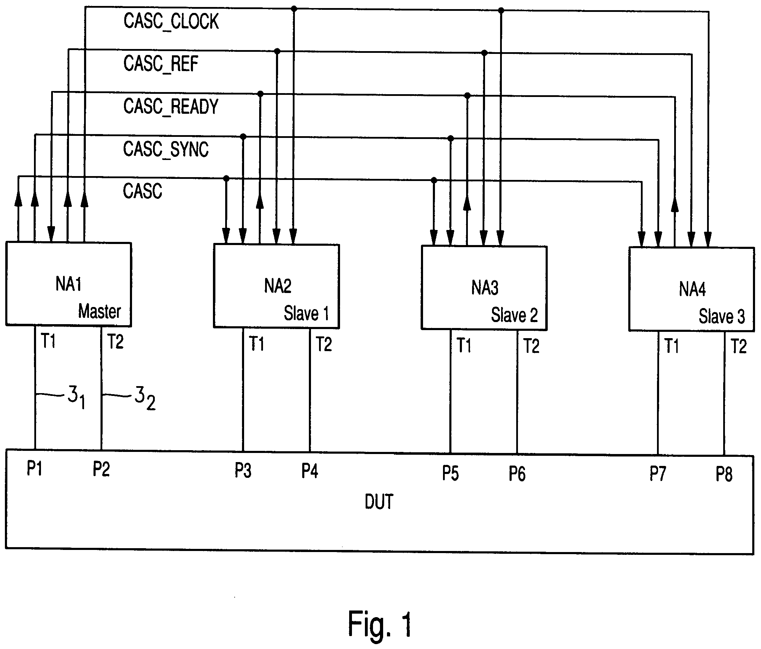

Fig. 1 zeigt ein überblickartiges Blockschaltbild der erfindungsgemäßen Anordnung zur Phasensynchronisation. Mehrere Messgeräte, beispielsweise Netzwerkanalysatoren NA1, NA2, NA3, NA4 aber auch beispielsweise Spektrumanalysatoren, sollen zu einem Meßgeräteverbund zusammengeschaltet werden. Dies ist beispielsweise deshalb notwendig, weil die einzelnen Meßgeräte, insbesondere Netzwerkanalysatoren, jeweils nur zwei Meßtore T1 und T2 haben, das Meßobjekt (DUT = device under test) jedoch mehrere Eingangs- und Ausgangstore P1, P2, P3, P4, P5, P6, P7 und P8 hat, welche gleichzeitig zu vermessen sind. Dabei soll eine exakte Messung der Phasenlage der Meßsignale in Bezug auf die Phasenlage der Anregungssignale erreicht werden. Beispielsweise könnte das Meßobjekt DUT an seinen Toren P1 und P2 durch einen ersten Netzwerkanalysator NA1 durch ein differentiales Signal (differential mode) angeregt werden, wobei im differential mode die an den Toren T1 und T2 des Netzwerkanalysators NA1 zu erzeugenden Signale einen exakten Phasenunterschied von 180° haben müssen. Die anderen Tore P3 bis P8 können beispielsweise Ausgangstore des Messobjekts sein, wobei es an jedem Tor P3 bis P8 darauf ankommt, die exakte Phasenlage in Bezug auf das Anregungssignal zu messen.

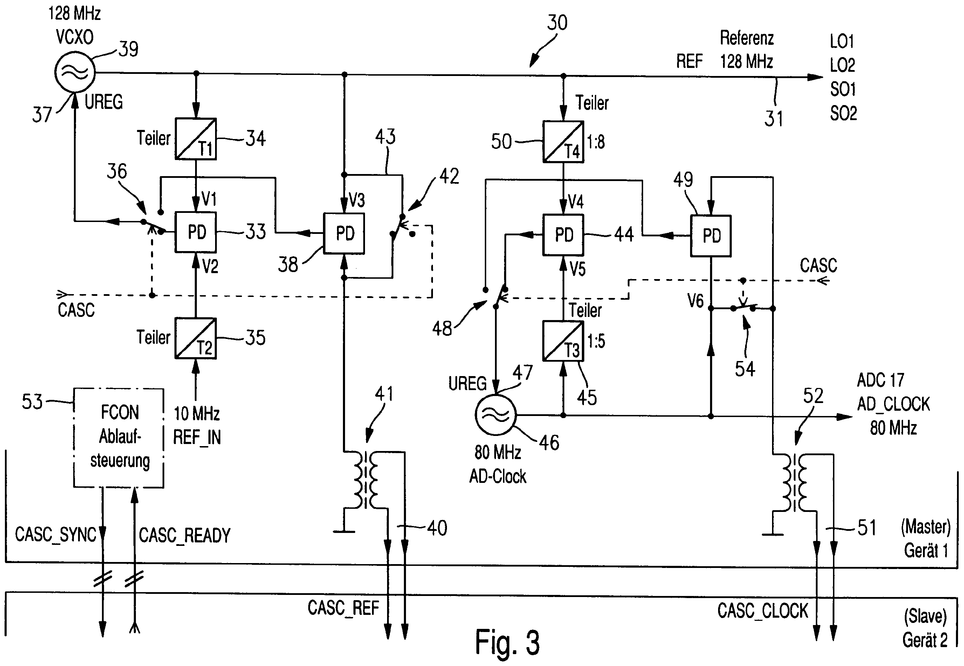

Um dies zu erreichen, wird erfindungsgemäß vorgeschlagen, eines der Messgeräte, im in Fig. 1 gezeigten Beispiel das Messgerät NA1, als Haupt-Gerät (Master) zu betreiben und die anderen Messgeräte, im in Fig. 1 gezeigten Beispiel die Meßgeräte NA2, NA3, NA4, als dem Haupt-Gerät NA1 untergeordnete Geräte (Slaves) zu betreiben. Dazu teilt zunächst das Haupt-Gerät NA1 über das Signal CASC den anderen Geräten NA2 bis NA4 mit, dass es eine Zusammenschaltung (Kaskadierung) wünscht und es bei dieser Meßaufgabe das übergeordnete Gerät (Master) sein wird. Daraufhin werden die anhand von Fig. 3 noch zu erläuternden Umschalteinrichtungen in den einzelnen Meßgeräten in die entsprechende Schaltstellung gebracht. Durch die Anfrage CASC_SYNC fragt das Haupt-Gerät NA1 die untergeordneten Geräte NA2 bis NA4 ab, ob der Umschaltvorgang beendet ist. Die Geräte NA2 bis NA4 bestätigen dies über das Signal CASC-READY. In dieser Konfiguration versorgt das Haupt-Gerät NA1 die untergeordneten Geräte NA2 bis NA4 mit einem Referenzsignal CASC_REF und im dargestellten bevorzugten Ausführungsbeispiel zusätzlich mit einem Takt-Signal CASC_CLOCK.

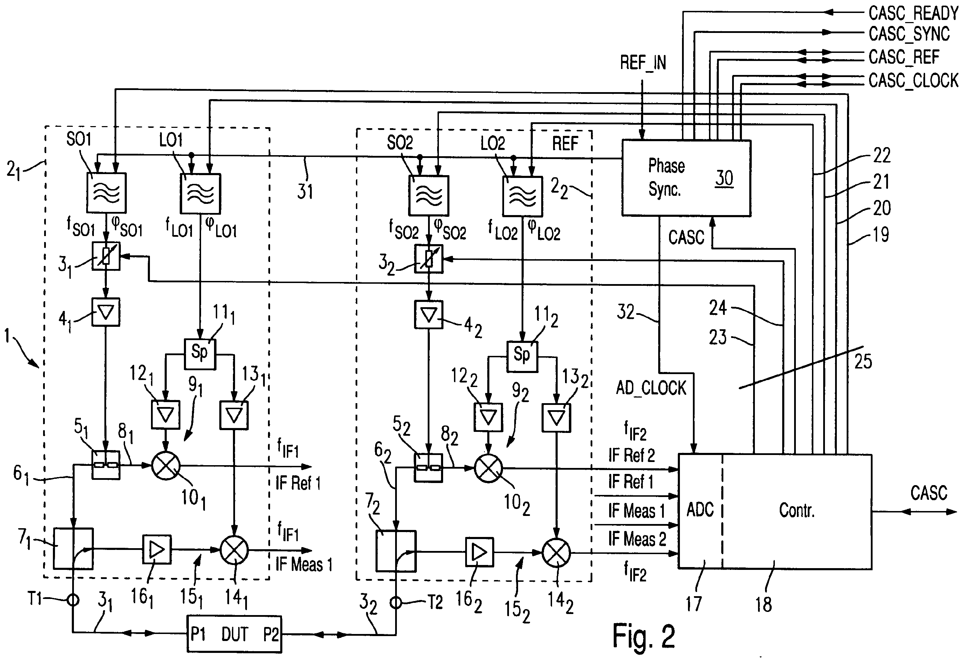

Zum besseren Verständnis dafür, warum das Referenzsignal CASC_REF und das Referenz-Taktsignal CASC_CLOCK benötigt wird, ist in Fig. 2 ein Beispiel für den internen Aufbau eines Netzwerkanalysators angegeben. Nach dem in Fig. 2 dargestellten Blockschaltbild können die in Fig. 1 dargestellten Netzwerkanalysatoren NA1 bis NA4 intern aufgebaut sein.

Fig. 2 zeigt ein Ausführungsbeispiel einer der Meßvorrichtungen NA1 - NA4, bei welcher die erfindungsgemäße Phasensynchronisation benutzt wird. Im gezeigten Ausführungsbeispiel handelt es sich bei den Meßvorrichtungen um einen vektoriellen Netzwerkanalysator. Die Meßvorrichtung ist jedoch nicht auf Netzwerkanalysatoren eingeschränkt. Dargestellt ist das Ausführungsbeispiel des 2-Tor-Netzwerkanalysators NA1. Dabei ist hervorzuheben, daß das erfindungsgemäße Konzept bei vektoriellen Netzwerkanalysatoren nicht auf 2-Tor-Netzwerkanalysatoren beschränkt ist, sondern sich auch bei Mehrtor-Netzwerkanalysatoren mit mehr als zwei Meßtoren eignet.

Bei dem dargestellten Ausführungsbeispiel ist an jedem Tor T1, T2 des Netzwerkanalysators NA1 eine separate Anregungs-/Empfangseinheit 2₁ bzw. 2₂ vorhanden. Jede Anregungs-/Empfangseinheit 2₁ bzw. 2₂ verfügt über einen Signalgenerator SO1 bzw. SO2, mit welchem das Meßobjekt DUT mit einem Anregungssignal beaufschlagbar ist. Es kann entweder nur einer der beiden Signalgeneratoren SO1 bzw. SO2 aktiv sein oder es können auch beide Signalgeneratoren SO1 und SO2 jeweils ein Anregungssignal aussenden.

Im in Fig. 1 dargestellten Anwendungsfall ist das Meßobjekt DUT ein 8-Tor. Jedes der beiden ersten Tore P1 und P2 des Meßobjekts DUT ist über eine Meßleitung 3₁ bzw. 3₂ mit einem der beiden Tore T1 bzw. T2 des ersten Netzwerkanalysators NA1 verbunden.

Die Signalgeneratoren SO1 und SO2 sind jeweils über ein variables Dämpfungsglied 3₁ bzw. 3₂ und jeweils einen Verstärker 4₁ bzw. 4₂ mit einem Signal-Verteiler (signal splitter) 5₁ bzw. 5₂ verbunden. Ein Signalzweig 6₁ bzw. 6₂ steht jeweils über eine Brücke (z.B. Richtkoppler) 7₁ bzw. 7₂ mit dem zugeordneten Tor T1 bzw. T2 in Verbindung. Der andere Zweig 8₁ bzw. 8₂ ist mit einem Mischer 10₁ bzw. 10₂ einer ersten Empfangseinrichtung 9₁ bzw. 9₂ der jeweiligen Anregungs-/Empfangseinheit 2₁ bzw. 2₂ verbunden. Die erste Empfangseinrichtung 9₁ bzw. 9₂ empfängt somit, wenn der zugehörige Signalgenerator SO1 bzw. SO2 aktiv ist, das Anregungssignal. Ferner wird dem Mischer 10₁ bzw. 10₂ ein Oszillatorsignal zugeführt, das von einem internen Oszillator LO1 bzw. LO2 der jeweiligen Anregungs-/Empfangseinheit 2₁ bzw. 2₂ erzeugt wird und dem Mischer 10₁ bzw. 10₂ über einen Signal-Verteiler (signal splitter) 11₁ und 11₂ und jeweils einen Verstärker 12₁ bzw. 12₂ zugeführt wird.

Der gleiche Oszillator LO1 bzw. LO2 versorgt über den anderen Signalzweig der Signal-Verteiler 11₁ bzw. 11₂ und einen entsprechenden Verstärker 13₁ bzw. 13₂ einen Mischer 14₁ bzw. 14₂ einer zweiten Empfangseinrichtung 15₁ bzw. 15₂ der jeweiligen Anregungs-/Empfangseinheit 2₁ bzw. 2₂. Der Mischer 14₁ bzw. 14₂ steht über einen Isolations-Verstärker 16₁ bzw. 16₂ und die Brücke 7₁ bzw. 7₂ mit dem zugeordneten Tor T1 bzw. T2 in Verbindung. Somit erhält die zweite Empfangseinrichtung 15₁ das von dem zugehörigen Tor T1 empfangene, von dem Meßobjekt zum Tor T1 reflektierte oder durch das Meßobjekt DUT von dem Tor T1 zum Tor T2 transmittierte Signal. Entsprechend empfängt die zweite Empfangseinrichtung 15₂ der Anregungs-/Empfangseinheit 2₂ das von dem Meßobjekt DUT zum Tor T2 reflektierte oder durch das Meßobjekt DUT vom Tor T1 zum Tor T2 transmittierte Signal. Die Mischer 10₁ und 14₁ der ersten Anregungs-/Empfangseinheit 2₁ setzen das empfangene Signal in eine erste Zwischenfrequenzlage mit der Zwischenfrequenz f_{IF1} um, während die Mischer 10₂ und 14₂ der zweiten Anregungs-/Empfangseinheit 2₂ das empfangene Signal in eine zweite Zwischenfrequenzlage mit der Zwischenfrequenz f_{IF2} umsetzen. Dabei sind die Zwischenfrequenzen f_{IF1} und f_{IF2} nicht notwendigerweise identisch.

Das von den Mischern 10₁ bzw. 10₂ erzeugte Zwischenfrequenz-Referenzsignal IF Ref 1 bzw. IF Ref 2 sowie das von den Mischern 14₁ bzw. 14₂ erzeugte Zwischenfrequenz-Meßsignal IF Meas 1 bzw. IF Meas 2 wird einem Analog/Digital-Wandler 17 zugeführt, welcher mit einer Signalauswertungs- und Steuereinheit 18 in Verbindung steht. In dieser erfolgt eine Auswertung der Referenzsignale und der Meßsignale. Die Signalauswertungs- und Steuereinheit 18 steuert ferner über Steuerleitungen 19, 20, 21 und 22 die Signalgeneratoren SO1 und SO2 sowie die Oszillatoren LO1 und LO2 so an, daß diese ein Signal mit vorbestimmter Frequenz f_{SO1}, f_{LO1}, f_{SO2} bzw. f_{LO2} und mit vorbestimmter Phase ϕ_{SO1}, ϕ_{LO1}, ϕ_{SO2} und ϕ_{LO2} erzeugen.

Über weitere Steuerleitungen 23 und 24 steht die Auswerte- und Steuereinheit 18 mit den einstellbaren Dämpfungsgliedern 3₁ und 3₂ in Verbindung, so daß die Signalamplitude des von den Signalgeneratoren SO1 und SO2 erzeugten Anregungssignals steuerbar ist. Da die Ist-Amplitude des Anregungssignals über die Zwischenfrequenz-Referenzsignale IF Ref 1 und IF Ref 2 erfaßt werden, kann auf diese Weise eine Regelschleife zur exakten Regelung der Anregungsamplitude gebildet werden.

Die Steuerleitungen 19 bis 23 können zu einem Bus-System 25, insbesondere einem LAN-Bus-System, zusammengefaßt werden. Durch unterschiedliche Einstellung der Phasen ϕ_{LO1}, ϕ_{LO2} bzw. ϕ_{SO1}, ϕ_{SO2} können Laufzeitunterschiede, beispielsweise in den Meßleitungen 3₁ und 3₂ ausgeglichen werden.

Es sei nochmals betont, daß die erfindungsgemäße Weiterbildung sich nicht nur auf Netzwerkanalysatoren bezieht, sondern auch in anderen Meßvorrichtungen sinnvoll ist.

Gemäß der erfindungsgemäßen Ausbildung hat der in Fig. 2 dargestellte Netzwerkanalysator eine Phasensynchronisationseinheit 30, die von den Netzwerkanalysatoren die anhand der in Fig. 1 beschriebenen Signale CASC_READY, CASC_SYNC, CASC_REF und CASC_CLOCK empfängt bzw. an diese aussendet. In der Steuereinheit 18 wird festgelegt, ob der jeweilige Netzwerkanalysator übergeordnet (Master) oder untergeordnet (Slave) ist. Beispielsweise kann die Bedienperson an dem jeweiligen Netzwerkanalysator eingeben, dass dieser Netzwerkanalysator NA1 das übergeordnete Haupt-Gerät (Master) sein soll. Dieser Netzwerkanalysator NA1 sendet dann das Signal CASC an die übrigen Netzwerkanalysatoren NA1 - NA4, die daraufhin wissen, dass sie die untergeordneten Netzwerkanalysatoren (Slaves) bei der anstehenden Meßaufgabe sind. Außerdem wird das Signal CASC an die Phasensynchronisationseinheit 30 gesandt, wo daraufhin Umschalteinrichtungen betätigt werden, die noch später anhand der Fig. 3 erläutert werden.

Über eine Verbindungsleitung 31 steht die Phasensynchronisationseinheit 30 mit den Signalgeneratoren SO1 und SO2 sowie den lokalen Oszillatoren LO1 und LO2 in Verbindung und gibt diesen ein Haupt-Referenzsignal REF vor. Mit dem Analog/Digital-Wandler 17 steht die Phasensynchronisationseinheit 30 über eine Verbindungsleitung 32 in Verbindung und übermittelt an diese das Taktsignal AD_CLOCK zur Festlegung der Abtastzeit. Das zur Erzeugung des Haupt-Referenzsignals REF benötigte Hilfs-Referenzsignal REF_IN kann entweder extern zugeführt werden oder innerhalb des Netzwerkanalysators erzeugt werden.

Fig. 3 zeigt als Blockschaltbild ein Ausführungsbeispiel des Aufbaus der Phasensynchronisations-Einheit 30. Ein steuerbarer Oszillator 39 erzeugt das Haupt-Referenzsignal REF. Ein erster Phasendetektor 33 empfängt ein erstes Vergleichssignal V2. Im dargestellten Ausführungsbeispiel ist das erste Vergleichssignal V1 aus dem Haupt-Referenzsignal REF dadurch abgeleitet, dass die Frequenz des Haupt-Referenzsignals in einem ersten Teiler 34 durch einen ersten Teilerfaktor T1 geteilt wird. Das zweite Vergleichssignal V2, dessen Phase mit der Phase des ersten Vergleichssignals V1 verglichen wird, wird aus dem Hilfs-Referenzsignal REF_IN abgeleitet. Dazu wird im dargestellten Ausführungsbeispiel die Frequenz des Hilfs-Referenzsignals REF_IN in einem zweiten Teiler 35 durch einen zweiten Teilerfaktor T2 geteilt. Am Ausgang des ersten Phasendetektors 33 entsteht somit ein Regelsignal, welches ein Maß für die Phasenabweichung zwischen den beiden Vergleichssignalen V1 und V2 ist. Dieses ist über eine erste Umschalteinrichtung 36 als Regelsignal UREG einem Regeleingang 34 des Oszillators 39 zuführbar.

Die in Fig. 3 dargestellte Schaltstellung entspricht der Situation, dass das der Phasensynchronisationseinheit 30 zugeordnete Gerät NA1 das Haupt-Gerät (Master) ist. In dieser Situation schaltet die erste Umschalteinrichtung 36 den Ausgang des ersten Phasendetektors 33 auf den Regeleingang 37 des geregelten Oszillators 39. Ist das zugehörige Gerät jedoch ein untergeordnetes Gerät (Slave), so befindet sich die erste Umschalteinrichtung 36 in der oberen Schaltstellung und verbindet den Ausgang eines zweiten Phasendetektors 38 mit dem Regeleingang 37 des Oszillators 39.

Das erste Vergleichssignal V3, das dem zweiten Phasendetektor 38 zugeführt wird, ist das Haupt-Referenzsignal REF. Das andere Vergleichssignal ist das Haupt-Referenzsignal des Haupt-Geräts, welches im Ausführungsbeispiel über eine Zweidraht-Verbindungsleitung 40 und einen Transformator 41 dem anderen Eingang des zweiten Phasendetektors 38 zugeführt wird. Eine zweite Umschalteinrichtung 42 schließt die Verbindungsleitung 43 nur dann, wenn das zugehörige Gerät das Haupt-Gerät (Master) ist. Wenn das Gerät ein untergeordnetes Gerät (Slave) ist, so ist die Leitung 43 geöffnet; in diesem Fall findet somit ein Phasen-Vergleich zwischen dem Haupt-Referenzsignal REF und dem von dem Haupt-Gerät zugeführten Referenzsignal CASC_REF statt.

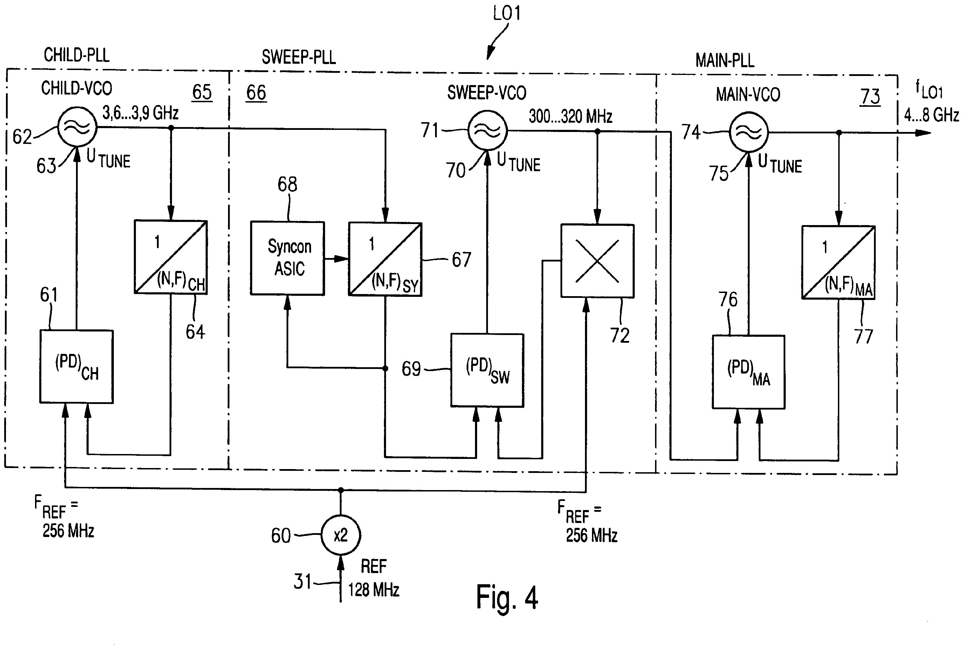

In der in Fig. 3 gezeigten Schaltstellung für den Master-Betrieb besteht somit eine geschlossene Phasen-Schleife vom Ausgang des Oszillators 39 über den Teiler 34, den Phasendetektor 33 zum Regeleingang 37 des Oszillators 39, wobei der Phasenvergleich mit dem Hilfs-Referenzsignal REF_IN erfolgt. Bei dem Slave-Betrieb hingegen besteht eine geschlossene Phasenschleife vom Ausgang des Oszillators 39 über den zweiten Phasendetektor 38 zum Regeleingang 37 des Oszillators 39, wobei der Phasenvergleich dann mit dem Haupt-Referenzsignal REF des Master-Geräts erfolgt. Auf diese Weise ist sichergestellt, dass die Phasenregelschleifen aller Geräte synchron zueinander arbeiten und die Oszillatoren 39 aller Geräte phasensynchrone Referenzsignale REF erzeugen, die den jeweiligen Signalgeneratoren SO1, SO2 und lokalen Oszillatoren LO1, LO2 der jeweiligen Geräte zugeführt werden, die dann ebenfalls synchron zueinander arbeiten, was später anhand von Fig. 4 genauer beschrieben wird.

Eine weitere Aufgabe der Phasensynchronisations-Einheit 30 besteht bei einem bevorzugten Ausführungsbeispiel darin, für die Synchronität der Taktsignale der Analog/DigitalWandler zu sorgen. Hierzu ist ein dritter Phasendetektor 44 vorhanden, der die Phase eines vierten Vergleichssignals V4 mit der Phase eines fünften Vergleichssignals V5 vergleicht. Das fünfte Vergleichssignal V5 wird über einen dritten Teiler 45 aus dem Taktsignal AD_CLOCK abgeleitet, wobei der dritte Teiler 45 die Frequenz des Taktsignals AD_CLOCK durch einen dritten Teilerfaktor T3 teilt. Das vierte Vergleichssignal V4 ist über einen vierten Teiler 50 aus dem Haupt-Referenzsignal REF abgeleitet, wobei der vierte Teiler 50 die Frequenz des Haupt- Referenzsignals REF durch den Teilungsfaktor T4 teilt. Das Taktsignal AD_CLOCK für die Analog/Digital-Wandler 17 wird mittels eines zweiten Oszillators 46 erzeugt, dessen Regeleingang 47 über eine dritte Umschalteinrichtung 48 mit dem Ausgang des dritten Phasendetektors 44 verbindbar ist. Über das Signal CASC ist diese Verbindung nur für den Fall geschaltet, dass das betreffende Gerät das Haupt-Gerät (Master) ist. Für den Fall, dass es sich bei dem Gerät um ein untergeordnetes Gerät (Slave) handelt, schaltet die dritte Umschalteinrichtung 48 den Regeleingang 47 des zweiten Oszillators 46 auf den Ausgang eines vierten Phasendetektors 49.

Für den Fall, dass es sich bei dem Gerät um ein untergeordnetes Gerät (Slave) handelt, verbindet die dritte Umschalteinrichtung 48 den Regeleingang 47 des zweiten Oszillators 46 jedoch mit dem Ausgang eines vierten Phasendetektors 49. Eines der Vergleichssignale, die dem vierten Phasendetektor 49 zugeführt werden, ist das von dem zweiten Generator 46 erzeugte Taktsignal AD_CLOCK. Das andere Vergleichssignal ist das Taktsignal CASC_CLOCK, welches von dem Master-Gerät über die Zweidraht-Verbindungsleitung 51 und den Transformator 52 zugeführt wird. Eine vierte Umschalteinrichtung 54 ist nur geschlossen, wenn das jeweilige Gerät das Master-Gerät ist. Dadurch wird dafür gesorgt, dass das von diesem Master-Gerät erzeugte Taktsignal AD_CLOCK über die Zweidrahtleitung als 50 als Taktsignal CASC_CLOCK an die untergeordneten Geräte (Slaves) übertragen wird und dort zur Synchronisation der Takt-Signale herangezogen werden kann. Somit sind alle durch die jeweiligen Phasensynchronisationseinheit 30 in den jeweiligen Geräten erzeugten Taktsignale AD_CLOCK miteinander synchronisiert.

Auch hier wird eine erste abgeschlossene Phasenregelschleife durch den zweiten Oszillator 46, den dritten Teiler 45 und den dritten Phasendetektor 44 geschaffen, wenn das jeweilige Gerät das Master-Gerät ist, wobei diese Phasenregelschleife auf das Haupt-Referenzsignal REF synchronisiert. Alternativ wird eine zweite geschlossene Phasenregelschleife durch den Generator 46 und den vierten Phasendetektor 49 geschaffen, wenn das jeweilige Gerät das Slave-Gerät ist, wobei in diesem Fall auf das externe Takt-Signal CASC_CLOCK synchronisiert wird.

Des Weiteren ist bevorzugt eine Ablaufsteuerung 53 vorhanden. Die Ablaufsteuerung 53 des Master-Geräts sendet den Befehl CASC_SYNC an alle Slave-Geräte, die daraufhin die Umschalteinrichtungen 36, 42, 48 und 54 betätigen. Die vollzogene Umschaltung wird durch das Signal CASC_READY an das Master-Gerät bestätigt.

Fig. 4 zeigt eine mögliche Realisierung eines der lokalen Oszillatoren LO1. Im Rahmen der Erfindung sind auch beliebig andere Realisierungen möglich. Anhand von Fig. 4 soll lediglich eine mögliche Verwendung des Haupt-Referenzsignals REF veranschaulicht werden.

Das Haupt-Referenzsignals REF wird von der Phasensynchronisationseinheit 30 an den lokalen Oszillator LO1 über die Verbindungsleitung 31 übertragen. In dem Ausführungsbeispiel wird in dem lokalen Oszillator LO1 zunächst die Frequenz des Haupt-Referenzsignals REF in einem Frequenzverdoppler 60 verdoppelt und innerhalb des lokalen Oszillators LO1 einem ersten Vergleichseingang ersten Phasendetektor 61 zugeführt. Des Ausgang des Phasendetektors 61 ist mit dem Regeleingang 63 eines ersten Oszillators 62 verbunden. Der Ausgang des ersten Oszillators 62 ist über einen ersten fraktionalen Teiler 64 mit dem zweiten Vergleichseingang des ersten Phasendetektors 61 verbunden. Folglich bildet der erste Oszillator 62 mit dem Teiler 64 und dem ersten Phasendetektor 61 eine erste PLL-Regelschleife, welche mit dem Haupt-Referenzsignal REF synchronisiert wird. Diese erste PLL-Regelschleife im Abschnitt 65 wird auch als Child_PLL bezeichnet.

Der sich daran anschließende Abschnitt 66 wird als Sweep_PLL bezeichnet. Dort ist ein zweiter Teiler 67 vorhanden, der mit dem Ausgang des ersten Oszillators 62 in Verbindung steht. Ein Synchronbaustein 68 sorgt für die Auswahl des gebrochen rational Teilungsfaktors (N,F)_{SY}. Der Ausgang des zweiten Teilers 67 steht mit einem ersten Vergleichseingang eines zweiten Phasendetektors 69 in Verbindung. Dessen Ausgang steht wiederum mit dem Regeleingang 70 eines zweiten Oszillators 71 in Verbindung. Der Ausgang des zweiten Oszillators 71 ist mit einem ersten Eingang eines Mischers 72 verbunden. Ein zweiter Eingang des Mischers 72 empfängt das von dem Frequenzverdoppler 60 verdoppelte Haupt-Referenzsignal REF. Der Ausgang des Mischers 72 steht mit dem zweiten Vergleichseingang des zweiten Phasendetektors 69 in Verbindung. Auf diese Weise wird durch den zweiten Oszillator 71, den Mischer 72 und den Phasendetektor 69 eine zweite PLL-Regelschleißfe gebildet, der auch über das Haupt-Referenzsignal REF synchronisiert ist.

In einem dritten Abschnitt 73, der als MAIN_PLL bezeichnet wird, befindet sich ein dritter Oszillator 74, dessen Regeleingang 75 mit einem dritten Phasendetektor 76 verbunden ist. Ein erster Vergleichseingang des dritten Phasendetektors 76 steht mit dem Ausgang des zweiten Oszillators 71 in Verbindung, während ein zweiter Vergleichseingang des dritten Phasendetektors 76 über einen dritten Teiler 77 mit dem Ausgang des dritten Oszillators 74 verbunden ist. Am Ausgang des dritten Oszillators 74, der auch als Haupt-Oszillator bezeichnet werden kann, steht das lokale Oszillator-Signal mit der Frequenz f_{LO1} zu Verfügung. Die Frequenz f_{LO1} ist dabei über eine Oktav, im Ausführungsbeispiel von 4 GHz bis 8 GHz, abstimmbar.

Durch die erfindungsgemäß zur Verfügung gestellte Phasensynchronisation-Einheit 30 wird bei jedem der miteinander verbundenen Geräte eine Synchronisation der Signalgeneratoren SO und der lokalen Oszillatoren LO hergestellt. Gleichzeitig wird eine Synchronisation der Abtastraten der Analog/Digital-Wandler 17 erreicht. Auf Grund der klaren Unterordnung der Slave-Geräte unter das eine Master-Gerät ergeben sich kurze Regelzeiten bzw. Einschwingzeiten.

Die Erfindung ist nicht auf das dargestellte Ausführungsbeispiel beschränkt. Insbesondere kommen als Meßgeräte nicht nur Netzwerkanalysatoren, sondern auch andere Meßgeräte wie Spektrumanalysatoren oder Oszilloskope in Betracht. Auch bezüglich Netzwerkanalysatoren kommen alternative Ausführungsbeispiele, insbesondere mit nur einem lokalen Oszillator LO1 bzw. LO2 für zwei oder mehrere Tore oder nur einem Signalgenerator SO1 bzw. SO2, welcher zwischen zwei oder mehreren Toren des Netzwerkanalysators umschaltbar ist, in Betracht. Auch die lokalen Oszillatoren LO können anders, als in Fig. 4 dargestellt, ausgestaltet sein.

## Patentansprüche

1. Anordnung zur Phasensynchronisation mehrerer Geräte, wobei ein Gerät Haupt-Gerät (Master) und die anderen Geräte untergeordnete Geräte (Slave) sind, mit jeweils einer Phasensynchronisations-Einheit (30) für jedes Gerät, die jeweils aufweist:
einen ersten geregelten Oszillator (39) zur Erzeugung eines Haupt-Referenzsignals (REF),
einen ersten Phasendetektor (33), der zur Regelung des ersten Oszillators (39) die Phase eines aus dem Haupt-Referenzsignal (REF) abgeleiteten ersten Vergleichssignals (V1) mit der Phase eines aus einem Hilfs-Referenzsignals (REF_IN) abgeleiteten zweiten Vergleichssignals (V2) vergleicht, wenn das Gerät selbst das Haupt-Gerät (Master)ist, und
einen zweiten Phasendetektor (38), der zur Regelung des ersten Oszillators (39) die Phase eines aus dem Haupt-Referenzsignal (REF) abgeleiteten dritten Vergleichssignals (V3) mit der Phase eines Referenzsignals (CASC_REF) vergleicht, das von der Phasensynchronisations-Einheit des Haupt-Geräts (Master) stammt, wenn das Gerät selbst nicht Haupt-Gerät (Master) sondern untergeordnetes Gerät (Slave) ist,
**dadurch gekennzeichnet,**
**dass** jede Phasensynchronisations-Einheit weiterhin aufweist:
einen zweiten geregelten Oszillator (46) zur Erzeugung eines Taktsignals (AD_CLOCK),
einen dritten Phasendetektor (44), der zur Regelung des zweiten Oszillators (46) die Phase eines aus dem Haupt-Referenzsignal (REF) abgeleiteten vierten Vergleichssignals (V4) mit der Phase eines aus dem Taktsignal (AD_CLOCK) abgeleiteten fünften Vergleichssignals (V5) vergleicht, wenn das Gerät selbst das Haupt-Gerät (Master)ist, und
einen vierten Phasendetektor (49), der zur Regelung des zweiten Oszillators (46) die Phase eines aus dem Taktsignal (AD_CLOCK) abgeleiteten sechsten Vergleichssignals (V6) mit der Phase eines Referenz-Taktsignals (CASC_CLOCK) vergleicht, das von der Phasensynchronisations-Einheit (30) des Haupt-Geräts (Master) übermittelt wird, wenn das Gerät selbst nicht Haupt-Gerät (Master) sondern untergeordnetes Gerät (Slave) ist.

2. Anordnung zur Phasensynchronisation nach Anspruch 1,
**dadurch gekennzeichnet,**
**dass** jede Phasensynchronisations-Einheit (30) eine erste Umschalteinrichtung (36) aufweist, die einen Regeleingang (37) des ersten Oszillators (39) zwischen einem Ausgang des ersten Phasendetektors (33) und einem Ausgang des zweiten Phasendetektors (38) in Abhängigkeit davon umschaltet, ob das jeweilige Gerät Haupt-Gerät (Master) oder untergeordnetes Gerät (Slave) ist.

3. Anordnung zur Phasensynchronisation nach Anspruch 1 oder 2,
**dadurch gekennzeichnet,**
**dass** jede Phasensynchronisations-Einheit (30) eine zweite Umschalteinrichtung (42) aufweist, die das Haupt-Referenzsignals (REF) den Phasensynchronisations-Einheiten (30) der untergeordneten Geräte (Slave) zuleitet, wenn das jeweilige Gerät das Haupt-Gerät (Master) ist.

4. Anordnung zur Phasensynchronisation nach einem der Ansprüche 1 bis 3,
**dadurch gekennzeichnet,**
**dass** jede Phasensynchronisations-Einheit (30) einen ersten Teiler (34) aufweist, der die Frequenz des Haupt-Referenzsignals (REF) durch einen ersten Teilerfaktor (T1) zur Erzeugung des ersten Vergleichssignals (V1) teilt, das dem ersten Phasendetektor (33) zugeführt wird.

5. Anordnung zur Phasensynchronisation nach einem der Ansprüche 1 bis 4,
**dadurch gekennzeichnet,**
**dass** jede Phasensynchronisations-Einheit (30) einen zweiten Teiler (35) aufweist, der die Frequenz des Hilfs-Referenzsignals (REF_IN) durch einen zweiten Teilerfaktor (T2) zur Erzeugung des zweiten Vergleichssignals (V2) teilt, das dem ersten Phasendetektor (33) zugeführt wird.

6. Anordnung zur Phasensynchronisation nach einem der Ansprüche 1 bis 5,
**dadurch gekennzeichnet,**
**dass** dem zweiten Phasendetektor (38) das Haupt-Referenzsignal (REF) direkt zugeführt wird.

7. Anordnung zur Phasensynchronisation nach einem der Ansprüche 1 bis 6,
**dadurch gekennzeichnet,**
**dass** jede Phasensynchronisations-Einheit (30) eine dritte Umschalteinrichtung (48) aufweist, die einen Regeleingang (47) des zweiten Oszillators (46) zwischen einem Ausgang des dritten Phasendetektors (44) und einem Ausgang des vierten Phasendetektors (49) in Abhängigkeit davon umschaltet, ob das jeweilige Gerät Haupt-Gerät (Master) oder untergeordnetes Gerät (Slave) ist.

8. Anordnung zur Phasensynchronisation nach einem der Ansprüche 1 bis 7,
**dadurch gekennzeichnet,**
**dass** jede Phasensynchronisations-Einheit (30) eine vierte Umschalteinrichtung (54) aufweist, die das Taktsignal (AD_CLOCK) den Phasensynchronisations-Einheiten (30) der untergeordneten Geräte (Slave) zuleitet, wenn das jeweilige Gerät das Haupt-Gerät (Master) ist.

9. Anordnung zur Phasensynchronisation nach einem der Ansprüche 1 bis 8,
**dadurch gekennzeichnet,**
**dass** jede Phasensynchronisations-Einheit (30) einen dritten Teiler aufweist, der die Frequenz des Haupt-Referenzsignals (REF) durch einen dritten Teilerfaktor (T4) zur Erzeugung des vierten Vergleichssignals (V4) teilt, das dem dritten Phasendetektor (44) zugeführt wird.

10. Anordnung zur Phasensynchronisation nach einem der Ansprüche 1 bis 9,
**dadurch gekennzeichnet,**
**dass** jede Phasensynchronisations-Einheit (30) einen vierten Teiler (45) aufweist, der die Frequenz des Taktsignals (AD_CLOCK) durch einen vierten Teilerfaktor (T3) zur Erzeugung des fünften Vergleichssignals (V5) teilt, das dem dritten Phasendetektor (44) zugeführt wird.

11. Anordnung zur Phasensynchronisation nach einem der Ansprüche 1 bis 10,
**dadurch gekennzeichnet,**
**dass** dem vierten Phasendetektor (49) das Taktsignal (AD_CLOCK) direkt zugeführt wird.

## Claims

1. Arrangement for phase synchronisation of a plurality of devices, wherein one device is the main device (master) and the other devices are subordinate devices (slaves), having in each case a phase synchronisation unit (30) for each device, which unit in each case comprises:
a first controlled oscillator (39) for generating a main reference signal (REF),
a first phase detector (33) which to control the first oscillator (39) compares the phase of a first comparison signal (V1) derived from the main reference signal (REF) with the phase of a second comparison signal (V2) derived from an auxiliary reference signal (REF_IN) when the device itself is the main device (master), and
a second phase detector (38) which to control the first oscillator (39) compares the phase of a third comparison signal (V3) derived from the main reference signal (REF) with the phase of a reference signal (CASC_REF) which comes from the phase synchronisation unit of the main device (master) when the device itself is not the main device (master) but a subordinate device (slave),
**characterised in that**
each phase synchronisation unit also comprises:
a second controlled oscillator (46) for generating a clock pulse signal (AD_CLOCK),
a third phase detector (44) which to control the second oscillator (46) compares the phase of a fourth comparison signal (V4) derived from the main reference signal (REF) with the phase of a fifth comparison signal (V5) derived from the clock pulse signal (AD_CLOCK) when the device itself is the main device (master), and
a fourth phase detector (49) which to control the second oscillator (46) compares the phase of a sixth comparison signal (V6) derived from the clock pulse signal (AD_CLOCK) with the phase of a reference clock pulse signal (CASC_CLOCK) which is transmitted by the phase synchronisation unit (30) of the main device (master) when the device itself is not the main device (master) but a subordinate device (slave).

2. Arrangement for phase synchronisation according to claim 1,
**characterised in that**
each phase synchronisation unit (30) comprises a first switching unit (36) which switches a control input (37) of the first oscillator (39) between an output of the first phase detector (33) and an output of the second phase detector (38) depending on whether the respective device is the main device (master) or a subordinate device (slave).

3. Arrangement for phase synchronisation according to claim 1 or 2,
**characterised in that**
each phase synchronisation unit (30) comprises a second switching unit (42) which supplies the main reference signal (REF) to the phase synchronisation units (30) of the subordinate devices (slaves) when the respective device is the main device (master).

4. Arrangement for phase synchronisation according to one of claims 1 to 3,
**characterised in that**
each phase synchronisation unit (30) comprises a first divider (34) which divides the frequency of the main reference signal (REF) by a first division factor (T1) to generate the first comparison signal (V1) which is supplied to the first phase detector (33).

5. Arrangement for phase synchronisation according to one of claims 1 to 4,
**characterised in that**
each phase synchronisation unit (30) comprises a second divider (35) which divides the frequency of the auxiliary reference signal (REF_IN) by a second division factor (T2) to generate the second comparison signal (V2) which is supplied to the first phase detector (33).

6. Arrangement for phase synchronisation according to one of claims 1 to 5,
**characterised in that**
the main reference signal (REF) is supplied directly to the second phase detector (38).

7. Arrangement for phase synchronisation according to one of claims 1 to 6,
**characterised in that**
each phase synchronisation unit (30) comprises a third switching unit (48) which switches a control input (47) of the second oscillator (46) between an output of the third phase detector (44) and an output of the fourth phase detector (49) depending on whether the respective device is the main device (master) or a subordinate device (slave).

8. Arrangement for phase synchronisation according to one of claims 1 to 7,
**characterised in that**
each phase synchronisation unit (30) comprises a fourth switching unit (54) which supplies the clock pulse signal (AD_CLOCK) to the phase synchronisation units (30) of the subordinate devices (slaves) when the respective device is the main device (master).

9. Arrangement for phase synchronisation according to one of claims 1 to 8,
**characterised in that**
each phase synchronisation unit (30) comprises a third divider which divides the frequency of the main reference signal (REF) by a third division factor (T4) to generate the fourth comparison signal (V4) which is supplied to the third phase detector (44).

10. Arrangement for phase synchronisation according to one of claims 1 to 9,
**characterised in that**
each phase synchronisation unit (30) comprises a fourth divider (45) which divides the frequency of the clock pulse signal (AD_CLOCK) by a fourth division factor (T3) to generate the fifth comparison signal (V5) which is supplied to the third phase detector (44).

11. Arrangement for phase synchronisation according to one of claims 1 to 10,
**characterised in that**
the clock pulse signal (AD_CLOCK) is supplied directly to the fourth phase detector (49).

## Revendications

1. Agencement de synchronisation de phase de plusieurs appareils, dans lequel un appareil est un appareil principal (maître) et les autres appareils sont des appareils subordonnés (esclaves), avec respectivement une unité de synchronisation de phase (30) pour chaque appareil, chaque unité de synchronisation de phase comportant :
un premier oscillateur commandé (39) pour générer un signal de référence principal (REF),
un premier détecteur de phase (33) qui, pour commander le premier oscillateur (39), compare la phase d'un premier signal de comparaison (V1) obtenu à partir du signal de référence principal (REF) avec la phase d'un deuxième signal de comparaison (V2) obtenu à partir d'un signal de référence auxiliaire (REF_IN) si l'appareil est lui-même l'appareil principal (maître), et
un deuxième détecteur de phase (38) qui, pour commander le premier oscillateur (39), compare la phase d'un troisième signal de comparaison (V3) obtenu à partir du signal de référence principal (REF) avec la phase d'un signal de référence (CASC_REF) qui provient de l'unité de synchronisation de phase de l'appareil principal (maître) si l'appareil n'est pas lui-même l'appareil principal (maître) mais l'appareil subordonné (esclave),
**caractérisé en ce que**
chaque unité de synchronisation de phase comporte en outre :
un second oscillateur commandé (46) pour générer un signal d'horloge (AD_CLOCK),
un troisième détecteur de phase (44) qui, pour commander le second oscillateur (46), compare la phase d'un quatrième signal de comparaison (V4) obtenu à partir du signal de référence principal (REF) avec la phase d'un cinquième signal de comparaison (V5) obtenu à partir du signal d'horloge (AD_CLOCK) si l'appareil est lui-même l'appareil principal (maître), et
un quatrième détecteur de phase (49) qui, pour commander le second oscillateur (46), compare la phase d'un sixième signal de comparaison (V6) obtenu à partir du signal d'horloge (AD_CLOCK) avec la phase d'un signal d'horloge de référence (CASC_CLOCK) qui est transmis par l'unité de synchronisation de phase (30) de l'appareil principal (maître) si l'appareil n'est pas lui-même l'appareil principal (maître) mais l'appareil subordonné (esclave).

2. Agencement de synchronisation de phase selon la revendication 1, **caractérisé en ce que**
chaque unité de synchronisation de phase (30) comporte un premier dispositif de commutation (36) qui commute une entrée de commande (37) du premier oscillateur (39) entre une sortie du premier détecteur de phase (33) et une sortie du deuxième détecteur de phase (38) en fonction de si l'appareil respectif est l'appareil principal (maître) ou l'appareil subordonné (esclave).

3. Agencement de synchronisation de phase selon la revendication 1 ou 2,
**caractérisé en ce que**
chaque unité de synchronisation de phase (30) comporte un deuxième dispositif de commutation (42) qui fournit le signal de référence principal (REF) aux unités de synchronisation de phase des appareils subordonnés (esclaves) si l'appareil respectif est l'appareil principal (maître).

4. Agencement de synchronisation de phase selon l'une des revendications 1 à 3,
**caractérisé en ce que**
chaque unité de synchronisation de phase (30) comporte un premier diviseur (34) qui divise la fréquence du signal de référence principal (REF) par un premier facteur de division (T1) pour générer le premier signal de comparaison (V1) qui est fourni au premier détecteur de phase (33).

5. Agencement de synchronisation de phase selon l'une des revendications 1 à 4,
**caractérisé en ce que**
chaque unité de synchronisation de phase (30) comporte un second diviseur (35) qui divise la fréquence du signal de référence auxiliaire (REF_IN) par un deuxième facteur de division (T2) pour générer le deuxième signal de comparaison (V2) qui est fourni au premier détecteur de phase (33).

6. Agencement de synchronisation de phase selon l'une des revendications 1 à 5,
**caractérisé en ce que**
le signal de référence principal (REF) est directement fourni au deuxième détecteur de phase (38).

7. Agencement de synchronisation de phase selon l'une des revendications 1 à 6,
**caractérisé en ce que**
chaque unité de synchronisation de phase (30) comporte un troisième dispositif de commutation (48) qui commute une entrée de commande (47) du second oscillateur (46) entre une sortie du troisième détecteur de phase (44) et une sortie du quatrième détecteur de phase (49) en fonction de si l'appareil respectif est l'appareil principal (maître) ou l'appareil subordonné (esclave).

8. Agencement de synchronisation de phase selon l'une des revendications 1 à 7,
**caractérisé en ce que**
chaque unité de synchronisation de phase (30) comporte un quatrième dispositif de commutation (54) qui fournit le signal d'horloge (AD_CLOCK) aux unités de synchronisation de phase (30) des appareils subordonnés (esclaves) si l'appareil respectif est l'appareil principal (maître).

9. Agencement de synchronisation de phase selon l'une des revendications 1 à 8,
**caractérisé en ce que**
chaque unité de synchronisation de phase (30) comporte un troisième diviseur qui divise la fréquence du signal de référence principal (REF) par un troisième facteur de division (T4) pour générer le quatrième signal de comparaison (V4) qui est fourni au troisième détecteur de phase (44).

10. Agencement de synchronisation de phase selon l'une des revendications 1 à 9,
**caractérisé en ce que**
chaque unité de synchronisation de phase (30) comporte un quatrième diviseur (45) qui divise la fréquence du signal d'horloge (AD_CLOCK) par un quatrième facteur de division (T3) pour générer le cinquième signal de comparaison (V5) qui est fourni au troisième détecteur de phase (44).

11. Agencement de synchronisation de phase selon l'une des revendications 1 à 10,
**caractérisé en ce que**
le signal d'horloge (AD_CLOCK) est directement fourni au quatrième détecteur de phase (49).
